# EUROPEAN PATENT APPLICATION

(11) **EP 4 276 857 A1**
(43) Date of publication of application: **15.11.2023**
(21) Application number: 22771024.1
(22) Date of filing: 22.02.2022
(51) Int. Cl.: H01F 17/00, H01F 30/10, H05K 1/14, H05K 1/16, H05K 3/36, H05K 3/46, H01F 27/28

(54) **MULTILAYER SUBSTRATE, INTEGRATED MAGNETIC DEVICE, POWER SOURCE APPARATUS, AND MULTILAYER SUBSTRATE PRODUCTION METHOD**

(30) Priority: 19.03.2021 JP 2021045546
(71) Applicant: NEC Platforms, Ltd., Kanagawa 213-8511 (JP); NEC Corporation, 108-8001 Tokyo (JP)
(72) Inventor: TAHARA Hiromitsu, Kawasaki-shi, Kanagawa 213-8511 (JP)
(74) Representative: Vossius & Partner Patentanwälte Rechtsanwälte mbB
(86) International application number: PCT/JP2022/007283
(87) International publication number: WO 2022/196265

(57) **Abstract**

[Problem] To provide a technology that enables reduction in thermal resistance of a multilayer substrate.

[Solution] The multilayer substrate according to the present invention comprises: a plurality of substrates in which conductors are wired; and an insulation material to which first insulation particles each having a first particle diameter are added. The multilayer substrate has a lamination structure such that, in two of the substrates adjacent to each other among the plurality of substrates having been laminated, the first insulation particles, each having the first particle diameter substantially the same as the interval between the conductors on the two substrates, are disposed so as to be respectively brought into contact with the conductors wired on the adjacent two substrates.

## Description

### Technical Field

The present invention relates to a multilayer substrate, an integrated magnetic device, a power source apparatus, and a multilayer substrate production method, and more particularly to a multilayer substrate capable of forming a plurality of magnetic devices and a production method thereof, and an integrated magnetic device and a power source apparatus that use the multiplayer substrate.

### Background Art

In order to reduce a failure rate of a system that requires high reliability, a technique is employed in which hardware of the system is provided with a redundant structure. For example, a power source apparatus is provided with a redundant structure including two or more lines of power source circuits, and thus power can be supplied to the system by using a power source circuit in an operable line even when some of the lines of the power source circuits are stopped. With this, reliability of the system can be improved.

In a power source apparatus having a redundant structure including a plurality of lines, when power processing is in a balanced state, a power loss of a power device being used in each of power source lines is substantially uniform among the power source lines. As a result, a temperature rise of the power device can be kept low. Herein, the balanced state indicates a state in which all the power source lines operate normally and power dealt in all the power source lines is uniform.

In relation to the present invention, PTL 1 describes a coil structure body including a coil and an insulation sheet. PTL 2 describes an insulated converter in which a coil is formed by a multilayer substrate.

### Citation List

### Patent Literature

PTL 1: International Patent Publication No. WO 2017/208332
PTL 2: International Patent Publication No. WO 2017/221476

### Summary of Invention

### Technical Problem

In the power source device including a plurality of power source lines, when some of the power source lines are stopped, the remaining operating power source line is required to supply power to a load. In this case, power dealt in one power source line is increased, and hence a temperature of a power device in the remaining power source line is increased. Thus, a temperature rise of the power device approaches an allowable limit of each device, and hence there may be a risk that a problem such as limitation of power dealt in the entire power source apparatus or increase in size of the power device is caused. In particular, when the power source device is used in the ocean or in outer space, a cooling means of the power device is limited. A temperature rise of the power device causes degradation of reliability of a system, and hence suppression of a temperature rise of the power device is regarded as a problem to be solved.

Further, in a case of a magnetic device used in a power source circuit, in a winding body being a main body of the magnetic device, a generation loss is increased in proportion to a square of a current as a dealt power is increased. Moreover, in order to form an efficient magnetic circuit, the magnetic device, in most cases, has a complex steric structure using a magnetic body and a winding body. In view of this, it is desired that the magnetic device be capable of performing efficient heat radiation.

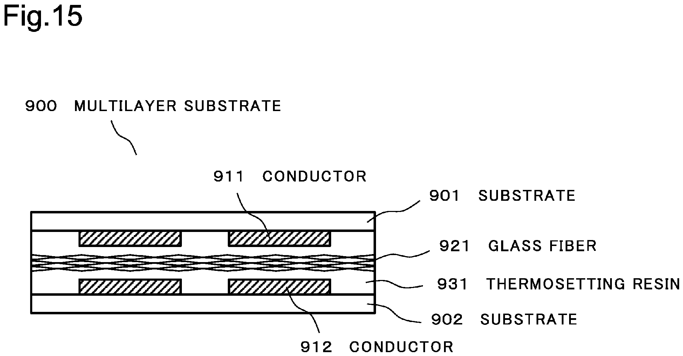

Fig. 15 is a diagram illustrating a cross-section of a general multilayer substrate 900 to be used as a winding body. The multilayer substrate 900 includes a substrate 901 including a conductor 911 and a substrate 902 including a conductor 912. The conductors 911 and 912 are electric wires each formed on the substrate 901 and the substrate 902. Between the substrate 901 and the substrate 902, a glass fiber 921 and a thermosetting resin 931 are present. The glass fiber 921 ensures dielectric strength between the conductor 911 and the conductor 912. The thermosetting resin 931 bonds the substrate 901 and the substrate 902.

Both materials of the glass fiber 921 and the thermosetting resin 931 being used in the configuration in Fig. 15 have relatively high thermal resistance as compared to metal. Thus, the multilayer substrate 900 has high thermal resistance, and thus there arises a problem that it is difficult to suppress a temperature rise of the magnetic device configured by using the multilayer substrate 900.

### (Object of Invention)

An object of the present invention is to provide a technique of enabling reduction in thermal resistance of a multilayer substrate.

### Solution to Problem

A multilayer substrate according to the present invention includes:
a plurality of substrates on which conductors are wired; and
an insulation material to which first insulation particles each having a first particle diameter are added, wherein
a lamination structure is formed between two substrates adjacent to each other among the plurality of substrates being laminated, and, in the lamination structure, the first insulation particles each having the first particle diameter substantially matching with an interval between the conductors on the two substrates are arranged in such a way as to contact with the conductors wired on the two substrates adjacent to each other.

A method of producing a multilayer substrate according to the present invention is a method of producing a multilayer substrate including a plurality of substrates on which conductors are wired, and the method includes procedures of:
selecting first insulation particles each having a first particle diameter, based on an interval between the conductors on the plurality of substrates being laminated;
adding the first insulation particles to an insulation material; and
laminating the plurality of substrates with the insulation material.

### Advantageous Effects of Invention

The present invention provides a technique of enabling reduction in thermal resistance of a multilayer substrate.

### Brief Description of Drawings

[Fig. 1] Fig. 1 is an example of a cross-sectional diagram of a multilayer substrate 100 of a first example embodiment.
[Fig. 2] Fig. 2 is a flowchart illustrating an example of a production procedure of the multilayer substrate.
[Fig. 3] Fig. 3 is a diagram illustrating an example of a cross-sectional diagram of a multilayer substrate 100A.
[Fig. 4] Fig. 4 is a diagram illustrating a configuration example of a power source apparatus 800.
[Fig. 5] Fig. 5 is a diagram illustrating an example of terminal arrangement of a transformer T 1.
[Fig. 6] Fig. 6 is a diagram illustrating an example of terminal arrangement of a transformer T2.
[Fig. 7] Fig. 7 is a diagram illustrating an example of terminal arrangement of a coil L1.
[Fig. 8] Fig. 8 is a diagram illustrating an example of terminal arrangement of a coil L2.
[Fig. 9] Fig. 9 is an example of a top diagram of a multilayer substrate 251.
[Fig. 10] Fig. 10 is an example of a top diagram and a side diagram of a magnetic body 281.
[Fig. 11] Fig. 11 is an example of a top diagram of an integrated magnetic device 201.
[Fig. 12] Fig. 12 is an example of a top diagram and a side diagram of a block 301 provided to the multilayer substrate 251.
[Fig. 13] Fig. 13 is an example of a bottom diagram and a side diagram of the integrated magnetic device 201 including the block 301.
[Fig. 14] Fig. 14 is a diagram illustrating a configuration example of an integrated magnetic device 830 of a third example embodiment.
[Fig. 15] Fig. 15 is a diagram illustrating a cross-section of a general multilayer substrate 900.

### Example Embodiment

With reference to the drawings, example embodiments of the present invention are described below in detail. Aforementioned elements are denoted with the identical reference symbols in the example embodiments and the drawings, and overlapping description therefor is omitted.

### (First Example Embodiment)

A magnetic device using a multilayer substrate is configured by combining a winding body and a magnetic body used as a core of the winding body. The winding body is produced by laminating substrates on which conductors are wired on surfaces with an adhesive. The adhesive is a material (insulation material) that insulates the facing substrates. A typical material of the conductors is copper. Copper has low electric resistance and low thermal resistance, and is relatively low in price. A typical insulation material is a thermosetting resin. In the present application, the "multilayer substrate" may also be referred to as a "lamination substrate".

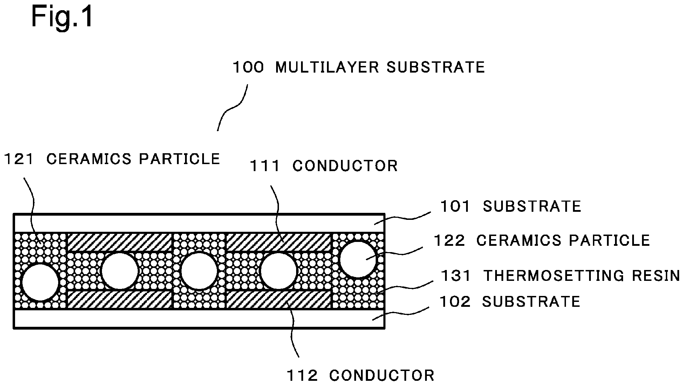

In the present example embodiment, description is made on the multilayer substrate used in the magnetic device. Fig. 1 is an example of a cross-sectional diagram of a multilayer substrate 100 of the first example embodiment of the present invention. The multilayer substrate 100 is a two-layer multilayer substrate in which substrates 101 and 102 forming two layers include facing conductors 111 and 112. The conductors 111 and 112 are formed on the substrate 101 and the substrate 102, respectively. The material of the substrates 101 and 102 is a glass epoxy resin, for example. For example, the conductors 111 and 112 are copper printed wires formed on the substrates 101 and 102, respectively. Conductors may be wired on both the surfaces of the substrates 101 and 102. The conductors 111 and 112 are connected via a through hole or the like between the substrates as appropriate in such a way that the conductors on the multilayer substrate 100 form the wiring bodies. The basic configuration in which the multilayer substrate forms the winding body is publicly known, and hence wiring of the winding body of the multilayer substrate is omitted in the description. Further, an example of an embodiment of the magnetic device using the winding body is described in the second example embodiment and thereafter.

In the multilayer substrate 100, when the substrate 101 and the substrate 102 are laminated, a thermosetting resin 131 to which two kinds of ceramics particles 121 and 122 having different particle diameters are added is used as an adhesive. A particle diameter d of the ceramics particles 121 is smaller than a particle diameter D of the ceramics particles 122. The particle diameter indicates an average diameter of the particles. The ceramics particles 121 each having a smaller particle diameter are added in such a way to prevent a significant loss in fluidity and filling ability of the thermosetting resin 131 filled between the substrate 101 and the substrate 102. The particle diameter d is 1 µm or smaller, for example.

Further, when the ceramics particles 122 each having a particle diameter larger than that of the ceramics particles 121 are filled between the conductor 111 and the conductor 112, a minimum distance between the conductor 111 and the conductor 112 is secured. For example, when the ceramics particles 122 each having the particle diameter D are added to the thermosetting resin 131, the ceramics particles 122 are filled between the conductor 111 and the conductor 112. Thus, the distance between the conductor 111 and the conductor 112 can be equal to or larger than D by adding the ceramics particles 122 to the thermosetting resin 131. In other words, the particle diameter D of the ceramics particles 122 may be set in such a way to secure the minimum interval between the conductor 111 and the conductor 112. Further, the particle diameter D may be equal to or larger than the interval required for insulation between the conductor 111 and the conductor 112. The particle diameter D may be selected to substantially match with the interval between the conductors 111 and 112 in the multilayer substrate 100. As the particle diameter D is increased, the distance between the conductor 111 and the conductor 112 is increased, and insulation performance is also improved. Meanwhile, as the particle diameter D is increased, the interval between the substrate 101 and the substrate 102 (in other words, the layer thickness of the thermosetting resin 131) is increased, and thermal resistance of the multilayer substrate 100 is increased. Thus, the particle diameter D of the ceramics particles 122 is preferably reduced within a range that insulation performance between the substrates can be secured.

In this manner, the ceramics particles 121 and 122 having different particle diameters are added to the thermosetting resin 131 used in the multilayer substrate 100. The thermosetting resin 131 to which the ceramics particles 121 and 122 are added is an example of the insulation material. When the substrates are laminated by using the thermosetting resin 131 described above, fluidity and filling ability of the thermosetting resin 131 are secured due to the ceramics particles 121 each having a smaller particle diameter. At the same time, the insulation distance between the substrates can be secured (in other words, insulation performance is secured) due to the ceramics particles each having a larger particle diameter.

In other words, with the configuration described above, the ceramics particles 121 each having a larger particle diameter can secure a substantially uniform insulation distance between the substrates, and hence a step of strictly adjusting the separation distance between the substrates can be omitted from the production steps of the multilayer substrate 100. In other words, according to the multilayer substrate 100, positioning between the substrates can be facilitated in the production steps, and hence an effect of improving productivity can be exerted.

At the time of producing the multilayer substrate 100, the particle diameters of the ceramics particles 121 and 122 are selected according to fluidity and filling ability of the thermosetting resin 131 and insulation performance of the multilayer substrate 100. The addition amount of the ceramics particles 122 is preferably an amount by which the ceramics particles 122 are sufficiently filled between the conductor 111 and the conductor 112 in the entire multilayer substrate 100. Further, a ratio of a volume or a mass occupied by the ceramics particles 121 in the thermosetting resin 131 may be greater than a ratio of a volume or a mass occupied by the ceramics particles 122 in such a way to secure fluidity and filling ability of the thermosetting resin 131.

When the addition amount of the ceramics particles 121 is increased, a larger amount of the thermosetting resin 131 can be replaced with the ceramics particles 121. With this, thermal resistance of the multilayer substrate 100 can further be reduced, and a thermal expansion coefficient of the multilayer substrate 100 can also be reduced. Reduction in thermal resistance contributes to expansion of heat radiation capacity of the multilayer substrate 100. Moreover, when the thermal expansion coefficient of the multilayer substrate 100 is reduced, a thermal expansion coefficient difference between the multilayer substrate 100 and a component of the multilayer substrate 100 that has a relatively small thermal expansion coefficient can be reduced. For example, when a ferrite core being a type of ceramics is used in the magnetic device using the multilayer substrate 100, a thermal expansion coefficient difference between the ferrite core and the multilayer substrate 100 can be reduced. When the thermal expansion difference is reduced, a margin of a gap with respect to the multilayer substrate 100 can be reduced at the time of mounting the ferrite core. Further, stress due to a temperature change applied to a contact part between the ferrite core and the multilayer substrate 100 may be reduced. As a result, while avoiding disadvantageous influence of interference between these components due to a temperature change, size reduction and improvement of reliability of the magnetic device using the multilayer substrate 100 can be achieved.

The thermosetting resin 131 to which the ceramics particles 121 and 122 are added is used to bond the substrate 101 and the substrate 102. Due to the ceramics particles 122 each having a larger particle diameter, the distance between the conductor 111 and the conductor 112 can be controlled easily and securely only by bonding the substrate 101 and the substrate 102. Further, with the ceramics particles 122, the distance between the substrates can be set to the minimum value required for insulation. As a result, the ratio of the volume and the mass occupied by the thermosetting resin 131 including the ceramics particles 121 and 122 in the entire multilayer substrate 100 is also reduced, and thermal resistance of the multilayer substrate 100 is also reduced. For example, in the magnetic device configured by using the multilayer substrate 100 including the plurality of winding bodies, even when only some of the winding bodies operate as the magnetic device, the entire multilayer substrate 100 is capable of efficiently radiating heat from the winding bodies, and hence a temperature rise of the winding bodies can be suppressed. This contributes to improvement of reliability of the magnetic device.

### (Alternative Configuration of First Example Embodiment)

The multilayer substrate including the following elements can also exert the effect of the multilayer substrate 100, that is, small thermal resistance. The reference symbols of the elements associated with those in Fig. 1 are denoted in the parentheses. Specifically, the multilayer substrate (100) includes the plurality of substrates (101 and 102) on which the conductors (111 and 112) are wired and the insulation material (131) to which the first insulation particles (122) each having the first particle diameter (D) are added. The multilayer substrate (100) has a lamination structure between the two substrates (101 and 102) adjacent to each other among the plurality of laminated substrates, the lamination structure in which the first insulation particles (122) are arranged to contact with the conductors (111 and 112) wired on the two substrates adjacent to each other. Here, the first insulation particles (122) each has the first particle diameter (D) that substantially matches with the interval between the conductors (111 and 112) on the two substrates.

In the multilayer substrate described above, the insulation particles (122) each having the first particle diameter that substantially matches with the interval between the conductors on the laminated substrates are added to the insulation material (131), and hence lamination can be performed with the predetermined interval between the substrates (101 and 102) only by laminating the substrate 101 and the substrate 102. With this configuration, the multilayer substrate (100) in which the thickness of the insulation material is small (in other words, thermal resistance is reduced) can easily be produced. Thus, even when some of the components mounted on the multilayer substrate 100 generate heat, a local temperature rise of the component generating heat and the periphery thereof can be avoided.

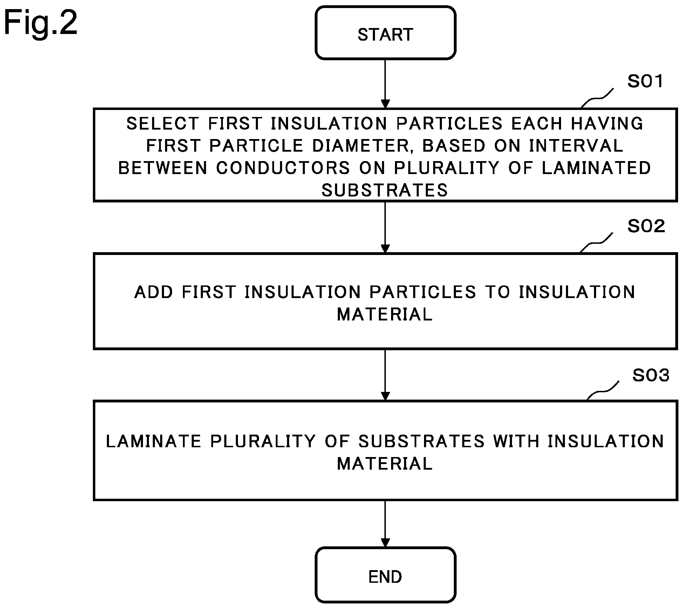

Fig. 2 is a flowchart illustrating an example of a production method of the multilayer substrate of the alternative configuration described above. First, the first insulation particles (122) each having the first particle diameter (D) are selected based on the interval between the conductors (111, 112) on the plurality of laminated substrates (Step S01 in Fig. 2). Further, the first insulation particles (122) are added to the insulation material (131) (Step S02). Finally, the plurality of substrates (101, 102) are laminated with the insulation material (131).

### (Modification Example of First Example Embodiment)

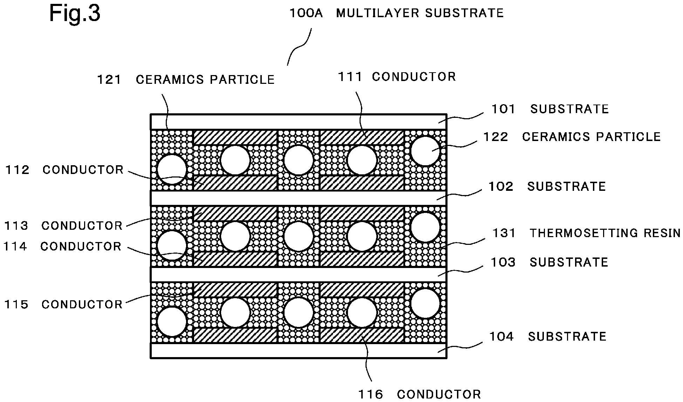

Fig. 3 is a diagram illustrating an example of a cross-sectional diagram of a multilayer substrate 100A. In the multilayer substrate 100A, substrates 103 and 104 are laminated in addition to the substrates 101 and 102 of the multilayer substrate 100. The thermosetting resin 131 to which the ceramics particles 121 and 122 are added as described in Fig. 1 is filled between the substrate 101 and the substrate 102, between the substrate 102 and the substrate 103, and between the substrate 103 and the substrate 104. In this manner, the structure of the multilayer substrate 100 in Fig. 1 is applicable to the multilayer substrate 100A having a larger number of layers. The number of turns of the winding body can be increased by multilayering the substrate. The number of layers in the multilayer substrate 100A may be greater.

### (Second Example Embodiment)

In the present example embodiment, description is made on an integrated magnetic device to be used in a power source apparatus having a redundant structure of two lines (in other words, "1+1").

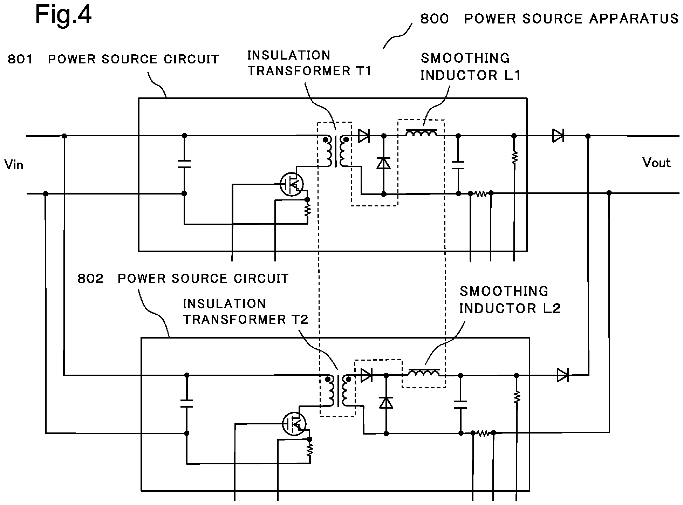

Fig. 4 is a diagram illustrating a configuration example of a power source apparatus 800 in which an integrated magnetic device of the present example embodiment is used. The power source apparatus 800 includes two power source circuits 801 and 802. The power source circuits 801 and 802 transforms a DC voltage Vin that is input, and outputs a DC voltage Vout. For example, Vin is equal to 57 V, and Vout is equal to 12 V. Vout is supplied to a load, which is not depicted.

In general, the power source circuits 801 and 802 operates at the same time. Further, when a failure occurs to one of the power source circuits 801 and 802, only the other power source circuit operates. For example, when a failure occurs to the power source circuit 801, the power source circuit 801 stops output of the DC voltage Vout, and only the power source circuit 802 outputs the DC voltage Vout. In this manner, the power source apparatus 800 has the "1+1" redundant structure including the two lines of power source circuits (the power source circuit 801 and the power source circuit 802).

The power source circuit 801 includes one insulation transformer T1 and one smoothing inductor L1 inside thereof. The configuration of the power source circuit 802 is similar to that of the power source circuit 801, and the power source circuit 802 includes one insulation transformer T2 and one smoothing inductor L2. Hereinafter, the insulation transformer T1 and the insulation transformer T2 are denoted as a transformer T1 and a transformer T2, respectively. Further, the smoothing inductor L1 and the smoothing inductor L2 are denoted as the coil L1 and the coil L2, respectively. An integrated magnetic device 201 described later is an electric component acquired by integrating the four magnetic devices including the transformers T1 and T2 and the coils L1 and L2 that are used in the power source apparatus 800. In Fig. 4, the four magnetic devices surrounded by the broken line are included in one integrated magnetic device 201.

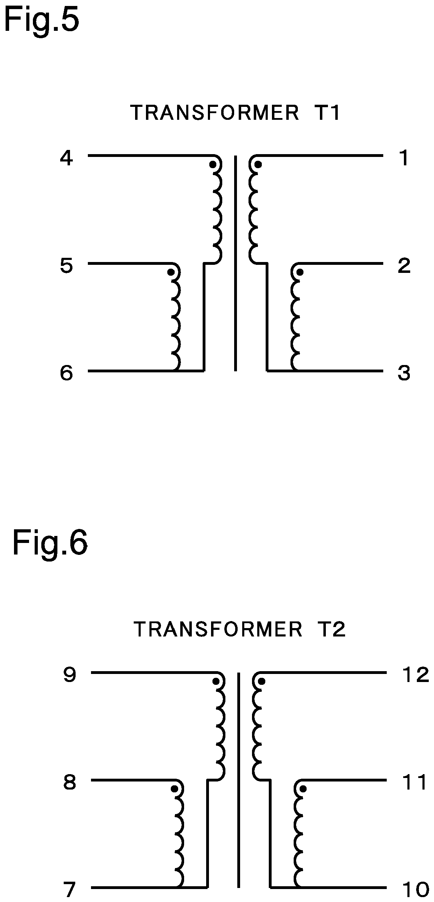

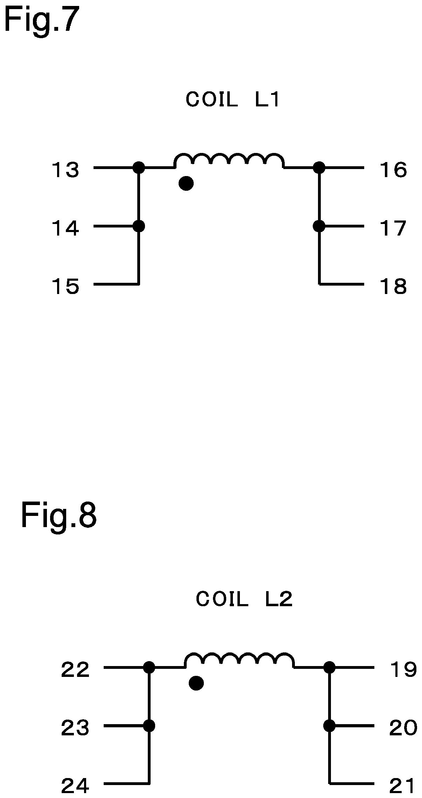

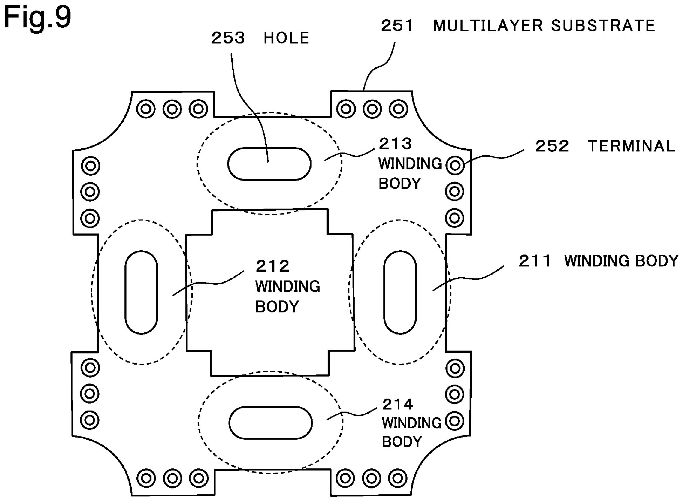

Fig. 5 to Fig. 8 are diagrams illustrating examples of terminal arrangement of the transformers T1 and T2 and the coils L1 and L2, respectively. Fig. 9 is an example of a top diagram of a multilayer substrate 251 used in the integrated magnetic device 201. Each of the transformers T1 and T2 and the coils L1 and L2 includes six terminals. In order to integrate the terminals, the multilayer substrate 251 includes twenty-four terminals 252 as illustrated in Fig. 9.

With reference to Fig. 9, winding bodies 211 and 212 associated with the transformers T1 and T2, respectively, and winding bodies 213 and 214 associated with the coils L1 and L2, respectively, are formed on one multilayer substrate 251. The winding bodies 211 to 214 are formed within ranges of the multilayer substrate 251, which are surrounded by the oval-shaped broken lines. At the center of the winding bodies 211 to 214, ellipsoidal holes 253 passing through the multilayer substrate 251 are opened. As described later, magnetic bodies are inserted into those four holes 253, and thus the winding bodies 211 to 214 exert predetermined functions as independent magnetic devices (in other words, as the transfers or the coils). The magnetic bodies inserted into the holes 253 are used as magnetic paths of the magnetic devices in longitudinal directions thereof.

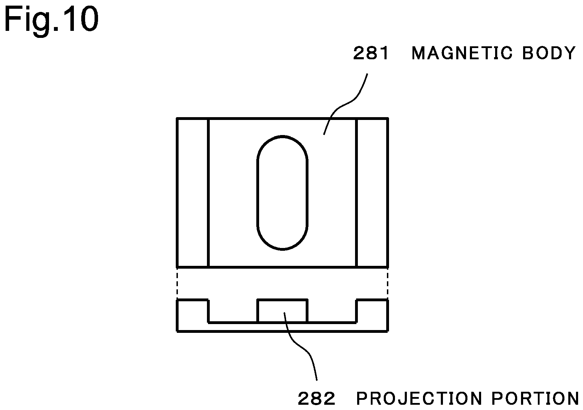

Fig. 10 is an example of a top diagram and a side diagram of a magnetic body 281 used in combination with each of the winding bodies 211 to 214. The magnetic body 281 is used as a core of each of the winding bodies 211 to 214. A material of the magnetic body 281 is ferrite, for example. The magnetic body 281 is mounted to the multilayer substrate 251 in such a way to sandwich each of the winding bodies 211 to 214 from the front side and the back side. One ellipsoidal projection portion 282 of the magnetic body 281 is inserted into one hole 253 from the front side and the back side of the multilayer substrate 251.

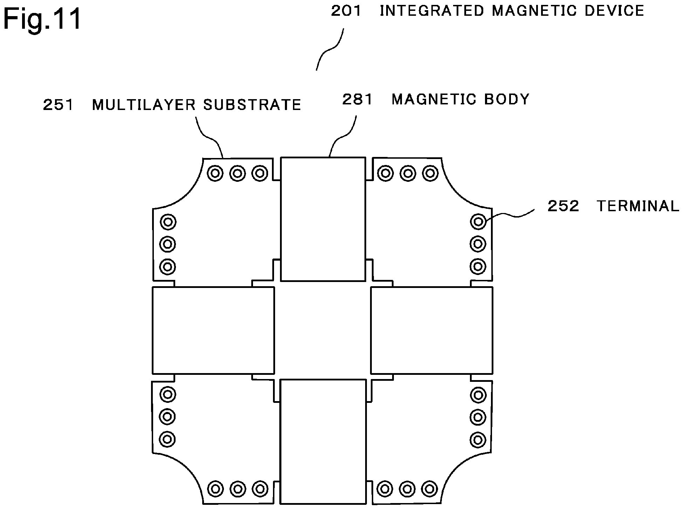

Fig. 11 is an example of a top diagram of the integrated magnetic device 201. The four magnetic bodies 281 are mounted to the multilayer substrate 251, and thus the multilayer substrate 251 functions as the integrated magnetic device 201. A fixing means for the magnetic body 281 and the multilayer substrate 251 is not particularly limited, and an adhesive may be used, for example.

The lamination structure of the substrates of the multilayer substrate 251 is similar to that of the multilayer substrate 100 or 100A of the first example embodiment described in Fig. 1 and Fig. 3. In other words, the multilayer substrate 251 is a multilayer substrate including two or more layers in which the substrates are laminated in a direction orthogonal to the paper sheet by using the thermosetting resin 131 to which the ceramics particles 121 and 122 having different particle diameters are added. On one multilayer substrate 251, the winding bodies 211 to 214 are configured by using the conductors by a known wiring method. The multilayer substrate 251 is produced by laminating the number of substrates that is calculated based on a specification of each of the transformers T1 and T2 and the coils L1 and L2. Similarly to the multilayer substrates 100 and 100A of the first example embodiment, the four winding bodies 211 to 214 integrated on the multilayer substrate 251 are coupled at low thermal resistance.

The twenty-four terminals 252 are connected to terminals of the winding bodies 211 to 214 formed on the conductors of the multilayer substrate 251, which are not depicted. The terminals 252 are terminals used at the time of mounting the transformers T1 and T2 and the coils L1 and L2 to a circuit substrate of the power source circuits 801 and 802. Wiring of the conductors of the multilayer substrate 251 is designed in such a way that each of the terminals 1 to 24 in Fig. 5 to Fig. 8 is connected to any one of the twenty-four terminals 252 in Fig. 9. An electric connection means between the terminals 252 and the circuit substrate of the power source circuits 801 and 802 is freely selective, and wiring is performed with a copper wire therebetween, for example. Not all the terminals 1 to 24 in Fig. 5 to Fig. 8 are required to be connected to the power source circuits 801 and 802. Only a terminal required for achieving the functions of the power source circuits 801 and 802 may be connected to the power source apparatus 800 via the terminal 252. In this manner, with the integrated magnetic device 201 using the multilayer substrate 251, the functions of the transformers T1 and T2 and the coils L1 and L2 that are used in the power source circuits 801 and 802 forming the two lines can be exerted by one component.

When the power source circuits 801 and 802 normally operate, both the power source circuits 801 and 802 supply the DC voltage Vout to the load. Thus, power is consumed at all the transformers T1 and T2 and the coils L1 and L2. Thus, all the winding bodies are heat sources due to generation of a power loss. When one of the power source circuits 801 and 802 is stopped due to a failure or the like, the other power circuit that continues operating supplies, to the load, the power supplied from the power source apparatus 800. In this case, the transformer and the coil of the operating power source circuit deal with power for the two power source circuits, and hence heat generation of the integrated magnetic device 201 is also concentrated on the transformer and the coil of the operating power source circuit. For example, when the power source circuit 801 is stopped, and only the power source circuit 802 operates, the transformer T1 and the coil L1 do not generate heat, and an amount of heat generation of the transformer T2 and the coil L2 (in other words, an amount of heat generation of the winding bodies 213 and 214) is significantly increased. Even in this case, because the substrates of the multilayer substrate 251 of the integrated magnetic device 201 are laminated at low thermal resistance, heat generated by the transformer T2 and the coil L2 efficiently propagates through the entire multilayer substrate 251, and the heat can be radiated from the entire integrated magnetic device 201. As a result, even when only the power source circuit 802 operates, heat is prevented from being generated only in the vicinity of the transformer T2 and the coil L2, and a local temperature rise of those magnetic devices can be suppressed.

For size reduction of the integrated magnetic device 201 and uniform heat distribution in the magnet devices, smaller distances between the winding bodies 211 to 214 are better. However, when the distance between the winding bodies is too small, a magnetic flux leaking from a magnetic path of a winding body is mixed into a magnetic path of another adjacent winding body, which may disadvantageously influence operations of the winding bodies. To avoid such disadvantageous influence, the winding bodies are preferably arranged in such a manner that the magnetic paths of the adjacent winding bodies are orthogonal to each other. On the multilayer substrate 251, the magnetic paths of the magnetic bodies 281 are orthogonal to each other for the adjacent winding bodies. For example, the magnetic path of the transformer T1 (the winding body 211) and the magnetic paths of the coil L1 (the winding body 212) and the coil L2 (the winding body 213) are orthogonal to each other. With such arrangement, unnecessary power propagation or mixing of noise due to a magnetic flux leaking from an adjacent magnetic device can be suppressed.

As described above, in the integrated magnetic device 201, the transformers T1 and T2 (insulation transformers) and the coils L1 and L2(smoothing inductors) used in the power source circuits 801 and 802 are integrated. Further, the substrates forming the multilayer substrate 251 of the integrated magnetic device 201 are laminated at low thermal resistance as described in the first example embodiment. Thus, in the integrated magnetic device 201, heat generated by the magnetic devices of the operating power source circuit can propagate through the entire integrated magnetic device 201 at low thermal resistance. As a result, the heat generated inside the integrated magnetic device 201 is dispersed to the entire integrated magnetic device 201 at low thermal resistance, and hence a local temperature rise of the magnetic devices used in the power source circuit can be suppressed.

### (Modification Examples of Second Example Embodiment)

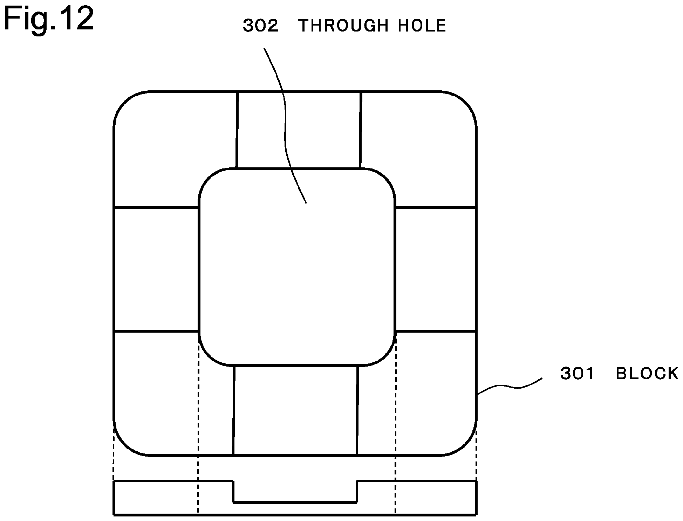

Fig. 12 is an example of a top diagram and a side diagram of a block 301 provided to the multilayer substrate 251. The multilayer substrate 251 may include the block 301 for further reduction in thermal resistance of the multilayer substrate 251. The block 301 is metal having a substantially rectangular frame-like shape, and the material is aluminum, for example. The block 301 has a through hole 302 at the center thereof, and has four notches in such a way to avoid contact with the magnetic body 281.

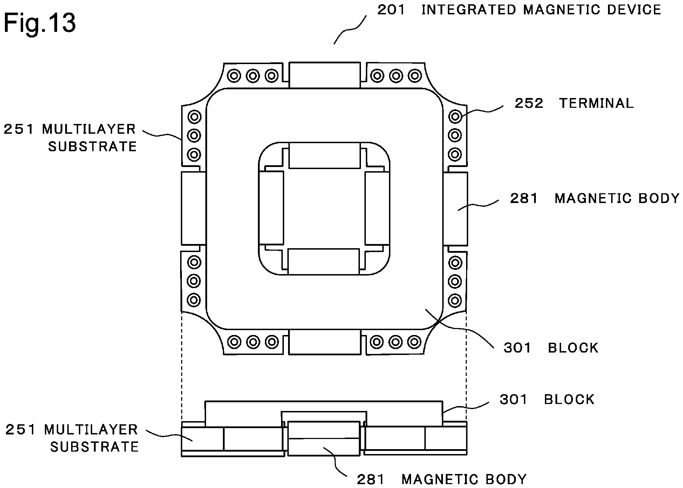

Fig. 13 is an example of a bottom diagram and a side diagram of the integrated magnetic device 201 including the block 301. The block 301 thermally couples the plurality of winding bodies 211 to 214, and thus further reduces thermal resistance of the multilayer substrate 251. The multilayer substrate 251 and the block 301 are joined in the vicinities of the winding bodies 211 to 214. For example, the multilayer substrate 251 and the block 301 may be joined by a metal composite, or may be joined by other means. The multilayer substrate 251 includes the block 301, and thus a temperature rise of the magnetic devices mounted to the integrated magnetic device 201 can further be suppressed.

In the second example embodiment and the modification examples, description is made on a case in which the power source apparatus 800 has the "1+1" redundant structure including the power source circuits 801 and 802. However, on the integrated magnetic device 201, magnetic devices used in power source circuits forming a plurality of, specifically, three or more lines may be mix-loaded. In this case, even when a failure occurs to the power source circuits in one or more lines, and as a result, a heat generation amount of the magnetic devices of the power source circuits in the remaining lines is increased, the integrated magnetic device 201 is capable of efficiently radiating the heat of the magnetic devices in the operating lines.

The magnetic devices mounted to the integrated magnetic device 201 are not limited to the transformers and the coils, and the number of magnetic devices is not limited to four. Moreover, even when an electric device other than the magnetic device is mounted to the multilayer substrate 251, a temperature rise of the electric device due to heat generation of the electric device can be suppressed because the multilayer substrate 251 has low thermal resistance.

### (Third Example Embodiment)

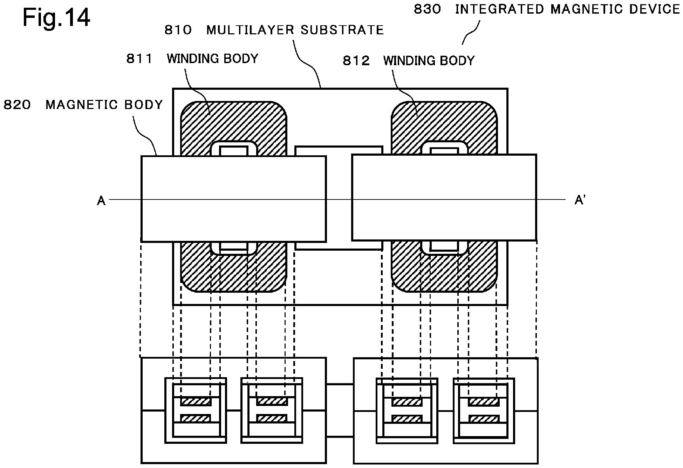

Fig. 14 is a diagram illustrating a configuration example of an integrated magnetic device 830 of the third example embodiment of the present invention. Fig. 14 illustrates an example of a top diagram of the integrated magnetic device 830 and an example of a cross-sectional diagram taken along the line A-A' of the top diagram. The integrated magnetic device 830 includes one multilayer substrate 810 and two magnetic bodies 820. The multilayer substrate 810 includes two winding bodies 811 and 812. Each of the winding bodies 811 and 812 is formed by a conductor formed on each layer of the multilayer substrate 810. Each of the winding bodies 811 and 812 is combined with the magnetic body 820, and thus operates as an independent magnetic device. For example, the magnetic device is a transformer or a coil, but is not limited thereto. As the magnetic bodies 820, two magnetic bodies 281 illustrated in Fig. 10 may be used for each of the winding bodies 811 and 812.

The multilayer substrate 810 is produced by a lamination method similar to that of the multilayer substrate 100 or 100A illustrated in Fig. 1 or Fig. 3, and is produced by laminating the plurality of substrates with the insulation material. For example, the insulation material is a resin to which insulation particles are added, the insulation particles each having a particle diameter selected based on an interval between the conductors forming the winding bodies between the substrates of the multilayer substrate 810.

In the integrated magnetic device 830 thus configured, the plurality of magnetic devices are integrated on one multilayer substrate 810. Further, the plurality of substrates forming the multilayer substrate 810 are laminated by using the resin to which the insulation particles each having the particle diameter selected based on an interval between the conductors forming the winding bodies. By using such a resin, the multilayer substrate having low thermal resistance and high insulation performance can easily be produced. Further, the integrated magnetic device 830 is capable of dispersing generated heat to the entire integrated magnetic device 830. Thus, even when any one of the plurality of the magnetic devices does not operate, the integrated magnetic device 830 is capable of suppressing a temperature rise of the operating magnetic device.

The whole or a part of the example embodiments described above can be described as, but not limited to, the following supplementary notes.

### [Supplementary Note 1]

A multilayer substrate, including:
a plurality of substrates on which conductors are wired; and
an insulation material to which first insulation particles each having a first particle diameter are added, wherein
a lamination structure is formed between two substrates adjacent to each other among the plurality of substrates being laminated, and, in the lamination structure, the first insulation particles each having the first particle diameter substantially matching with an interval between the conductors on the two substrates are arranged in such a way as to contact with the conductors wired on the two substrates adjacent to each other.

### [Supplementary Note 2]

The multilayer substrate according to Supplementary Note 1, wherein, in the insulation material, a ratio of second insulation particles is greater than a ratio of the first insulation particles, the second insulation particles each having a second particle diameter smaller than the first particle diameter.

### [Supplementary Note 3]

The multilayer substrate according to Supplementary Note 1 or 2, wherein a material of the first insulation particles is ceramics.

### [Supplementary Note 4]

The multilayer substrate according to any one of Supplementary Notes 1 to 3, further including a block thermally coupled to the conductors.

### [Supplementary Note 5]

The multilayer substrate according to any one of Supplementary Notes 1 to 4, wherein the conductors form winding bodies.

### [Supplementary Note 6]

An integrated magnetic device, including:
the multilayer substrate according to Supplementary Note 5 including a plurality of the winding bodies; and
a magnetic body in which the plurality of winding bodies are each arranged in such a way as to form a plurality of independent magnetic devices.

### [Supplementary Note 7]

The integrated magnetic device according to Supplementary Note 6, wherein the plurality of magnetic devices include at least one of an insulation transformer and a smoothing inductor.

### [Supplementary Note 8]

A power source apparatus having a redundant structure including a first line and a second line, the power source apparatus including
the integrated magnetic device according to Supplementary Note 6 or 7, wherein
one of the plurality of magnetic devices is used in the first line, and
another of the plurality of magnetic devices is used in the second line.

### [Supplementary Note 9]

A method of producing a multilayer substrate including a plurality of substrates on which conductors are wired, the method including:
selecting first insulation particles each having a first particle diameter, based on an interval between the conductors on the plurality of substrates being laminated;
adding the first insulation particles to an insulation material; and
laminating the plurality of substrates with the insulation material.

### [Supplementary Note 10]

The method of producing a multilayer substrate according to Supplementary Note 9, wherein
the first insulation particles each have the first particle diameter substantially matching with an interval between the conductors on two substrates adjacent to each other among the plurality of substrates being laminated, and
the multilayer substrate is formed by laminating the two substrates adjacent to each other for a plurality of times with the insulation material to which the first insulation particles each having the first particle diameter are added.

### [Supplementary Note 11]

The method of producing a multilayer substrate according to Supplementary Note 9 or 10 wherein the plurality of substrates are laminated in such a way that the conductors form winding bodies.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims. For example, the multilayer substrate and the integrated magnetic device given as examples in the example embodiments may be used in a transmitter, a receiver, a computer, and the like that have redundancy, in addition to the power source circuit. Further, even when the conductor of each of the substrates is other than the winding body, the configuration of each of the example embodiments enable efficient heat radiation from the conductor.

Further, the configurations of the example embodiments are not necessarily exclusive to each other. The actions and the effects of the present invention may be achieved by a configuration acquired by combining all or some of the above-mentioned example embodiments.

This application is based upon and claims the benefit of priority from Japanese patent application No. 2021-045546, filed on March 19, 2021, the disclosure of which is incorporated herein in its entirety by reference.

### Reference Signs List

100, 100A, 251, 810 Multilayer substrate
101 to 104 Substrate
111, 112 Conductor
121, 122 Ceramics particle
131 Thermosetting resin
201, 830 Integrated magnetic device
211 to 214 Wiring body
252 Terminal
253 Hole
281, 820 Magnetic body
282 Projection portion
301 Block
302 Through hole
800 Power source apparatus
801, 802 Power source circuit
811, 812 Wiring body
900 Multilayer substrate
901, 902 Substrate
911, 912 Conductor
921 Glass fiber
931 Thermosetting resin

## Claims

1. A multilayer substrate comprising:
a plurality of substrates on which conductors are wired; and
an insulation material to which first insulation particles each having a first particle diameter are added, wherein
a lamination structure is formed between two substrates adjacent to each other among the plurality of substrates being laminated, and, in the lamination structure, the first insulation particles each having the first particle diameter substantially matching with an interval between the conductors on the two substrates are arranged in such a way as to contact with the conductors wired on the two substrates adjacent to each other.

2. The multilayer substrate according to claim 1, wherein, in the insulation material, a ratio of second insulation particles is greater than a ratio of the first insulation particles, the second insulation particles each having a second particle diameter smaller than the first particle diameter.

3. The multilayer substrate according to claim 1 or 2, wherein a material of the first insulation particles is ceramics.

4. The multilayer substrate according to any one of claims 1 to 3, further comprising a block thermally coupled to the conductors.

5. The multilayer substrate according to any one of claims 1 to 4, wherein the conductors form winding bodies.

6. An integrated magnetic device comprising:
the multilayer substrate according to claim 5 including a plurality of the winding bodies; and
a magnetic body in which the plurality of winding bodies are each arranged in such a way as to form a plurality of independent magnetic devices.

7. The integrated magnetic device according to claim 6, wherein the plurality of magnetic devices include at least one of an insulation transformer and a smoothing inductor.

8. A power source apparatus having a redundant structure including a first line and a second line, the power source apparatus comprising
the integrated magnetic device according to claim 6 or 7, wherein
one of the plurality of magnetic devices is used in the first line, and
another of the plurality of magnetic devices is used in the second line.

9. A method of producing a multilayer substrate including a plurality of substrates on which conductors are wired, the method comprising:
selecting first insulation particles each having a first particle diameter, based on an interval between the conductors on the plurality of substrates being laminated;
adding the first insulation particles to an insulation material; and
laminating the plurality of substrates with the insulation material.

10. The method of producing a multilayer substrate according to claim 9, wherein
the first insulation particles each have the first particle diameter substantially matching with an interval between the conductors on two substrates adjacent to each other among the plurality of substrates being laminated, and
the multilayer substrate is formed by laminating the two substrates adjacent to each other for a plurality of times with the insulation material to which the first insulation particles each having the first particle diameter are added.

11. The method of producing a multilayer substrate according to claim 9 or 10 wherein the plurality of substrates are laminated in such a way that the conductors form winding bodies.
